# EUROPEAN PATENT APPLICATION

(11) **EP 2 045 788 A1**
(43) Date of publication of application: **08.04.2009**
(21) Application number: 07791414.1
(22) Date of filing: 26.07.2007
(51) Int. Cl.: G08B 13/22, G06K 19/07, G06K 19/077, H01L 41/12

(54) **MAGNETIC MARKER AND METHOD FOR MANUFACTURING SAME**

(30) Priority: 26.07.2006 JP 2006204013
(71) Applicant: NEXT Corporation, Tokyo 136-0076 (JP); Next Japan Korea Co., Ltd., Gyeonggi-Do (KR)
(72) Inventor: HONDA, Hisayoshi, Ichikawa-shi, Chiba 272-0133 (JP); TANABE, Isao, Tokyo 136-0074 (JP)
(74) Representative: TBK-Patent
(86) International application number: PCT/JP2007/064714
(87) International publication number: WO 2008/013245

(57) **Abstract**

Provided is a magnetic marker which surely gives warning from a vibration receiving side, by surely generating vibration. A magnetic marker (10) has a bent vibration plate (15) and a flat vibration plate (16) to be magnetostrictively vibrated in the main body (12A) of a case (12). On the main surface of an open section side of the case (12), a low coercive force magnet (20) is arranged to be magnetized and demagnetized. The magnetic marker (10) is attached to a commercial product (30) and the like by peeling a peeling sheet (24) of an adhesive tape (22). In the magnetic marker (10), as far as the low coercive force magnet (20) is not demagnetized, two sheets of the vibrating plates (15, 16) magnetostrictively vibrate upon passing through a gate. Thus, the vibration receiving side is surely made to give warning.

## Description

### Technical Field of the Invention

The present invention relates to a magnetic marker to be used for monitoring illegal acts of taking out an article (s) and giving a warning or alarm in the case of such illegal acts, and also relates to a device for producing the magnetic marker.

### Background Art

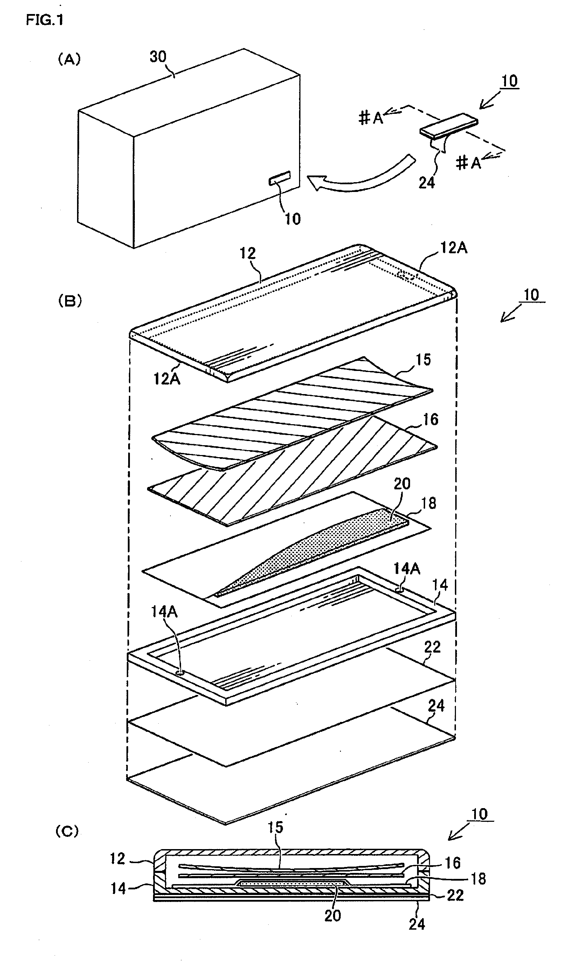

There are security systems for use in a retailer or shop, which are designed to monitor an illegal act (such as shoplifting or theft) for taking out article (s) or commodity without purchasing the same from the retailer or shop, and giving a warning or alarm in the case of such illegal acts. Among the security systems of this kind, known is a security system using a magnetic marker (or magnetic label), which is so designed that a warning sound or audible alarm is emitted from an alarm unit provided at entrance or exit of the retail store or shop in response to a vibration generated from a magnetic marker or label attached on an article. Such system includes a mechanism for deactivating the magnetic marker in response to payment done for a corresponding article bearing that magnetic marker, thereby insuring to prevent emission of warning sound or alarm with regard to the paid article being taken out from the shop. An example of the magnetic marker of this kind is disclosed from the patent literature 1 cited blow, according to which, a magnetic marker is shown in Fig. 1 of that literature as comprising a combination of magnetostrictor element and bias element provided in a housing of the magnetic marker.
Patent literature 1: Japanese Laid-Open Patent Publication No. Hei 8-87237 (Fig. 1)

### Disclosure of the Invention

### Problem to be Solved by the Invention

The aforementioned prior-art magnetic marker, however, can accommodate only one magnetostrictor element in the housing thereof, as a result of which, a vibration generated from that maker is not sufficient and thus the vibration can not be detected by a corresponding alarm unit in some instances. Some of the magnetic markers are each provided with a relatively soft housing, in which case, the housing itself may be depressed by applying external force thereto from user's fingers to forcibly suppress a vibration generated from the marker. Due to those factors, it is highly possible that an alarm unit may not completely detect a vibration from the magnetic marker, which may raise the problem that alarm and warning undesirably remains inoperative against the illegal act of taking out an article and so forth.

The present invention is made in view of the foregoing problems. It is therefore an object of the present invention to provide a magnetic marker which insures to generate a strong vibration sufficient to reach a vibration detecting side, thereby preventing that vibration detecting side from being inoperative to the magnetic marker for reliable alarm operation.

### Means for Solving the Problems

In order to achieve the above-stated object, a magnetic marker in accordance with the present invention is characterized by comprising: a first casing and a second hard casing, each being of hard property; a first vibrating plate and a second vibrating plate, each being capable of generating magnetostrictive vibration; and a substantially flat magnet which is to be magnetized and demagnetized by external action applied thereto, and also characterized in that the first vibration plate, the second vibrating plates and the substantially flat magnet element are stacked on one another inside of one casing formed by the first and second hard casings, and one of the first and second vibrating plates, which is juxtaposed upon the substantially flat magnet, is formed in a substantially flat fashion, whereas another of the first and second vibrating plates is formed in a curved fashion.

As one principal aspect of the present invention, the foregoing magnetic marker is characterized by further comprising: a third casing connected with the second casing; and an IC tag provided in a space defined between the second and third casings. As another aspect of the invention, the magnetic marker is characterized in that the afore-said substantially flat magnet is coated with a plastic coating and such plastic coating is adhesively bonded to a side of the afore-said one casing, so that the substantially flat magnet is fixed to that one casing. As still another aspect of the invention, the magnetic marker is characterized in that the outside dimensions of the afore-said one casing is such that the length, width and thickness of such one casing are 42 mm, 11.5 mm and 1.4 mm, respectively.

In accordance with the present invention, there is also provided a device for producing the above-described magnetic marker, which is characterized by comprising: support jig(s) having a capacity enough to allow resultant magnetic markers to be arrayed sequentially and retained therein; a transfer means for transferring the support jig(s) in an intermittent manner; a base-side-casing supply means for supplying a base-side casing(s) of hard property to the support jig(s), wherein the base-side casing(s) is one of the first and second casings which is to be situated on a base side of the afore-said one casing; an adhesive applying means for applying an adhesive to an inner side of the base-side casing retained by the support jig(s); a magnet supply means by which the substantially flat magnet is supplied to and placed on the thus-adhesive-applied inner side of the base-side casing; a first vibrating-plate supply means by which the afore-said one of the first and second vibrating plates is supplied to and placed on the substantially flat magnet supplied by the magnet supply means, wherein the afore-said one of the first and second vibrating plates is formed in the substantially flat fashion; a second vibrating-plate supply means by which the afore-said another of the first and second vibration plates is supped to and placed on the afore-said one of the first and second vibrating plates, wherein said another of said first and second vibrating plates is formed in the warped fashion; a cover-side casing supply means by which a cover-side casing(s) of hard property is supplied to and placed on the base-side casing(s) in which the substantially flat magnet and the first and second vibrating plates have been supplied and placed; a connecting means for connecting said cover-side casing and said base-cover casing; and a discharge means by which resultant magnetic markers, produced subsequent to the cover-side and base-side casings being connected together, are discharged outwardly from said support jig(s).

As one principal aspect, the above-described device is characterized in that the connecting means is operable to effect ultrasonic fusing to connect together the cover-side and base-side casings. As another aspect, the device is characterized by further comprising an outlet-side transfer means by which the resultant magnetic markers discharged by the discharge means are transferred outwardly from the device. It is to be understood that, in addition to the above-described purposes, features and advantages, another various purposes, features and advantages will become apparent from reading of the descriptions hereinafter, with reference to the annexed drawings.

### Advantageous Effects of the Invention

In accordance with the magnetic marker of the present invention, a hard casing is employed, which protects the vibrating plates against external force or pressure applied thereto, such external pressure attempting to forcibly prevent the magnetostrictive vibration of the vibrating plates. Therefore, the provision of hard casing insures that the vibrating plates generate magnetostrictive vibrations, even if the external pressure are strongly applied thereto. Further, in the present invention, an IC tag may be incorporated in the magnetic marker, in which case, it is possible to monitor articles, while checking and controlling the articles at the same time.

### Brief Description of the Drawings

[Fig. 1]: Fig. 1 shows an Embodiment 1 of the present invention. Namely, Fig. 1(A) is a schematic perspective view which explanatorily shows how a magnetic marker is applied to an article. Fig. 1(B) is an exploded perspective view of the magnetic marker. Fig. 1(C) is a cross-sectional view taken along the line #A - #A in the Fig. 1(A), which shows one side of the magnetic marker as viewed from the direction of arrows of that particular line.

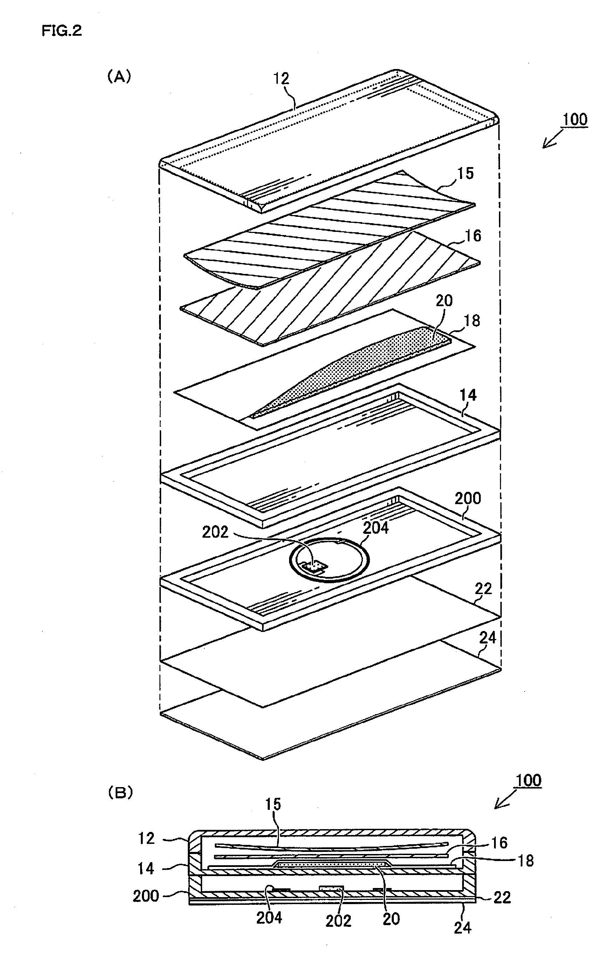

[Fig. 2]: Fig. 2 shows an Embodiment 2 of the present invention. Namely, Fig. 2(A) is an exploded perspective view of a magnetic marker in that embodiment. Fig. 2(B) is a sectional view showing a principal part of the magnetic marker in a cross-sectional manner similar to the foregoing Fig. 1(C).

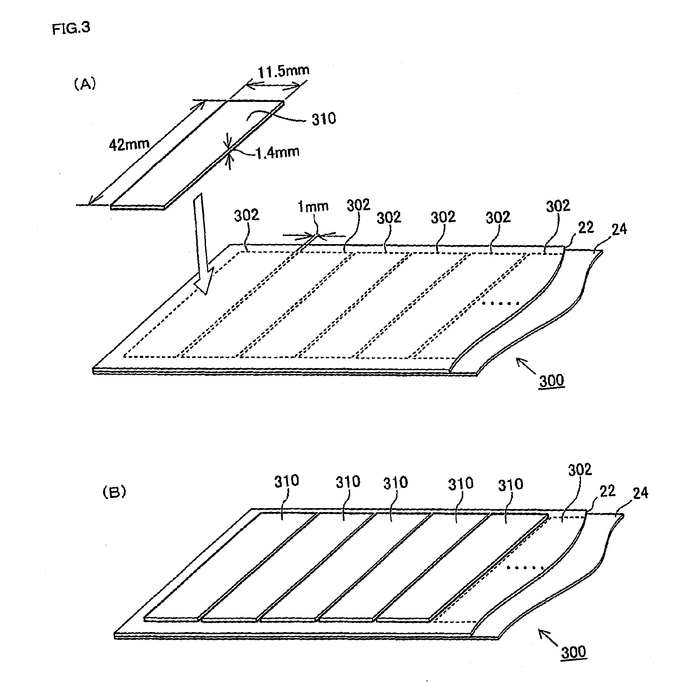

[Fig. 3]: Fig. 3 is a plan view showing an Embodiment 3 of the present invention. Namely, Fig. 3(A) is a schematic perspective view showing an adhesive sheet and perforations formed in that adhesive sheet. Fig. 3(B) is a schematic perspective view showing the state where the magnetic markers are attached to the adhesive sheet.

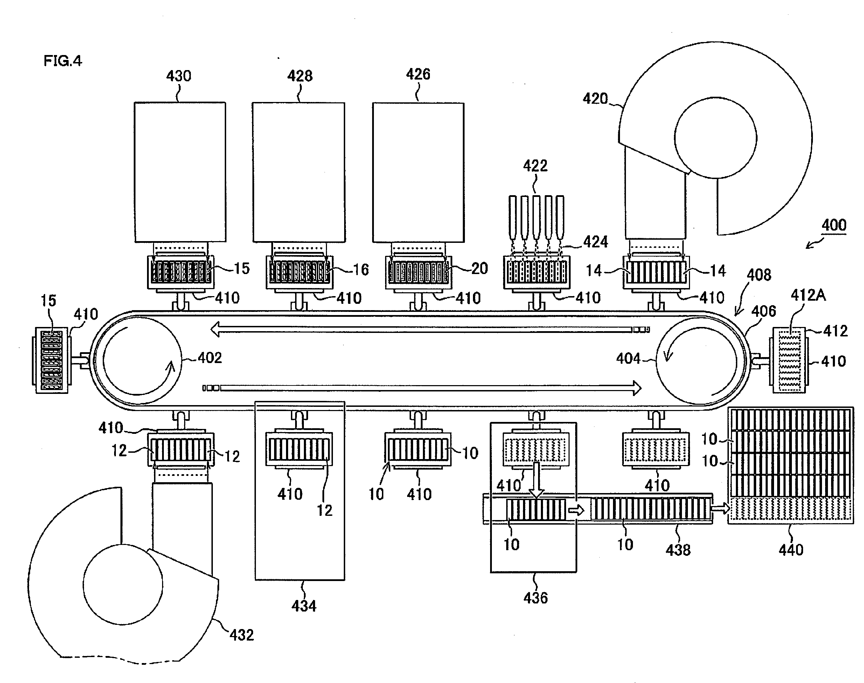

[Fig. 4]: Fig. 4 is a diagram showing an Embodiment 4 of the present invention, which illustrates a whole structure of a device for producing the magnetic marker.

### Description of Designations in the Drawings

- 10:: magnetic marker
- 11:: width
- 12:: upper casing
- 12A:: projected portion
- 14:: lower casing
- 14A:: recessed portion
- 15:: vibrating plate
- 16:: vibrating plate
- 18:: plastic coating
- 20:: low-coercive-force magnet
- 22:: adhesive tape
- 24:: release paper
- 30:: article
- 100:: magnetic marker
- 200:: casing
- 202:: IC tag
- 204:: antenna
- 300:: adhesive sheet
- 302:: perforated regions
- 310:: magnetic marker
- 400:: device for producing the magnetic marker
- 402: and 404: rollers, respectively
- 406:: endless belt
- 408:: transfer unit
- 410:: support jig
- 412:: plate
- 412A:: recessions
- 420:: base-side-casing supply unit
- 422:: adhesive applying unit
- 424:: adhesive
- 426:: magnet supply unit
- 428: and 430: vibrating-plate supply units, respectively
- 432:: cover-side-casing supply unit
- 434:: ultrasonic fusing unit
- 436:: discharge unit
- 438:: outlet-side transfer unit
- 440:: tray

### Best Mode for Carrying Out the Invention

The present invention may be embodied in a great number of various manners, but, hereinafter, some appropriate embodiments of the invention will be described in details.

### Embodiment 1

At first, a description will be made of a first embodiment of the present invention with reference to Fig. 1. Fig. 1(A) is a schematic perspective view for showing how a magnetic marker in accordance with the first embodiment is used. Fig. 1(B) is an exploded perspective view of the magnetic maker in accordance with the present first embodiment. Fig. 1(C) is a sectional view taken along the arrow lines #A - #A in the Fig. 1(A). It is to be noted that the magnetic markers shown in the three respective Figures differ from one another in shape and size with a view to facilitating the ease of understanding of the present embodiment. As shown in those Figures, the magnetic marker designated by 10 is adhered on a commodity or article 30 for the purpose of monitoring and detecting an illegal act of taking out that article 30 from a shop or the like without accounting process (i.e. without payment done for the article). The magnetic marker 10 is comprised of an upper casing 12 and a lower casing 14 and further comprised of a pair of vibrating plates 15 and 16 and a magnet 20 with low coercive force, wherein such low-coercive-force magnet 20 is coated with a vinyl or plastic coating 18, and wherein those vibrating plates 15 and 16 and magnet 20 are accommodated in one casing formed by the two casings 12 and 14. Furthermore, the magnetic marker 10 is comprised of an adhesive tape 22 and a release paper 24 removably attached on that adhesive tape 22.

The upper casing 12 has projected portions 12A formed in the connecting surface region thereof, whereas on the other hand, the lower casing 14 has: a connecting surface region adapted to be mated and fixedly connected with the mating surface region of the upper casing; and recessed portions 14A formed in such connecting surface region thereof. Thus, in assembly, the upper and lower casings 12 and 14 are fixedly connected together at their respective connecting surface regions, with the projected portions 12A inserted and secured in the respective recessed portions 14A, so that the upper and lower casings 12 and 14 are assembled together to provide one casing. Protrudent portions of the upper casing 12 (wherein the protrudent portions are all angled portions and four corner portions of the upper casing) are formed arcuate or round, so that any external thing to contact those protrudent portions will easily ride thereover and thus the upper casing will not be caught by the external thing. Otherwise, the upper casing will easily be caught by any external thing, raising the problem that the magnetic marker may be bodily removed from an article on which it is attached, or the upper casing 12 may be separated from the lower casing 14. Hence, such round formation of protrudent portions of upper casing effectively prevents the removal of magnetic marker and also prevents the separation of the upper casing from the lower casing. Both upper and lower casings 12 and 14 are formed from a hard material so as not to be easily depressed, wherein the hard material may be a suitable plastic material such as PS(polystyrene), for example.

As stated previously, provided in one casing formed by the upper and lower casings 12 and 14 are: the vibrating plates 15 and 16; and the low-coercive-force magnet 20 coated with the plastic coating 18. As shown, the vibrating plate 15 is juxtaposed on the vibrating plate 16 in a vertically stacked manner in that one casing, such that those two vibrating plates 15 and 16 are rowed in the direction of the thickness of the casings as well as in a substantially parallel relation with each other. Each of the vibrating plates is formed from an amorphous material having a thickness of approx. 100µm, wherein the amorphous material is a material that will generate magnetostrictive vibration responsive to a drive signal applied from the outside thereto under the condition that a bias magnetic field is applied by the low-coercive-force magnet 20 to that amorphous material. For example, such amorphous material usable in the present invention may be one of the following materials: iron; cobalt; copper; niobium; boron; and silicon. In particular, the vibrating plate 15, juxtaposed upon the vibrating plate 16, is so formed as to be curved transversely thereof, with the curvature thereof being defined along a part of the circumference of a circle whose diameter is approx. 50 mm. On the other hand, the vibrating plate 16 beneath the vibrating plate 15 is formed in substantially flat fashion. The reason that the upper vibrating plate 15 is formed in that transversely curved manner is based on the fact that, if the vibrating plate 15 is formed flat, the whole surface thereof is contacted with or attached to the lower vibrating plate 16, with the result that a sufficient magnetostrictive vibration is not generated from both of the two vibrating plates. Thus, the illustrated curved formation of the vibrating plate 15 effectively prevents the afore-stated full contact and attachment between the two vibrating plates.

With regard to the low-coercive-force magnet 20, the plastic coating 18 coated thereon is fixedly welded by ultrasonic fusing to the inner wall of the lower casing 14 and therefore the low-coercive-force magnet 20 itself is fixedly attached on that inner wall. This low-coercive-force magnet 20 may be formed from an amorphous sheet material that can be magnetized and demagnetized by a relatively low magnetic field. A material for forming such low-coercive-force magnet 20 may be one of the aforementioned materials usable for the vibrating plates 15 and 16, for instance. The adhesive tape 22 with the release paper 24 releasable attached thereto is fixedly attached on a reverse surface of the lower casing 14, as shown. Thus, the release paper 24 may be peeled off from the adhesive tape 22 to make that particular tape 22 effective, so that the magnetic marker 10 can be securely attached via the adhesive tape 22 to a goods or article 30. Of course, the adhesive tape 22 may be fixed on an outer surface of the upper casing 12. In this case, the protrudent portions of the lower casing 14 should be formed arcuate or round.

Next, a description will be made of the details of the present embodiment. The steps for producing the magnetic marker will be described as follows: The low-coercive-force magnet 20 coated with the plastic coating is placed in and securely attached to the lower casing 14, and then, the vibrating plate 15 is stacked on the vibrating plate 16 as one set of vibrating plates. Such one set of vibrating plates 15 and 16 is placed upon the afore-said low-coercive magnet 20. Thereafter, the upper casing 12 is brought to the lower casing 14 so as to cover those stacked elements, and the projected portions 12A of the upper casing are securely fitted in the respective recessed portions 12B of the lower casing, whereupon the upper and lower casings 12 and 14 are assembled together to provide one casing. At this time, the adhesive tape 22 is securely attached on the reverse surface of the lower casing 14, as shown.

It is to be noted here that the thus-produced magnetic marker 10 should be magnetized by applying a predetermined degree of magnetic field thereto, prior to the maker being attached on an article. Then, the release paper 24 is peeled off from the adhesive tape 24, after which, the magnetic marker 10 is secured to an article 30 via the adhesive tape. The article 30 bearing the magnetic maker 10 is placed on a display rack in a shop. A purchaser takes the article 30 and goes to a cash register to pay for that article. After the purchaser has paid for the article there, a person at the cash register uses an unshown demagnetizer device to demagnetize the low-coercive-force magnet 20 in the magnetic marker 10. Under such demagnetized state, when the purchaser goes out of the shop, having the article, the two vibrating plates 15 and 16 in the casing 12 do not generate any magnetostrictive vibration due to the afore-said demagnetization of low-coercive-force magnet 20, and therefore, no magnetostrictive vibration occurs, irrespective of the purchaser passing through a detection gate (not shown) adapted for detecting magnetostrictive vibration. Consequently, no audible alarm is emitted form the side of the detection gate.

By contrast, let us assume that the purchaser takes out the article 30 from the shop, without payment for that article. This means that the article 30 passes through the detection gate, without the low-coercive-force magnet 20 being demagnetized at the cash register. In that case, responsive to a detection signal emitted from the detection gate, the two vibrating plates 15 and 16 in the magnetic marker 10 generate magnetorestictive vibration. At this point of time, the detection gate detects such magnetostrictive vibration and immediately causes emission of an audible alarm or causes a warning light to turn on. With this arrangement, any illegal act of taking out the article 30 is noticed by surrounding people in the shop.

In the present embodiment, the above-described magnetic elements are enclosed with the casings of hard material for protection, and therefore the magnetic marker itself has a sufficient strength to withstand a great external force applied thereto, thereby insuring that the magnetic elements generate magnetostrictive vibration without influence of the external force. This in turn causes reliable activation of alarm. In addition thereto, the provision of two vibrating plates 15 and 16 insures generation of the magnetostrictive vibration. This indeed permits use of a magnet with low coercive force as the magnet 20 adapted for application of bias magnetic field, which means that such low-coercive-force magnet 20 can be readily demagnetized, while preventing malfunction. Further, since the magnetostrictive vibration is positively effected as stated above, a quick activation of alarm is realized in an optimum manner against any illegal act of taking out the article. Still further, the use of double-sided adhesive tape 22 not only makes assembly of the magnetic marker 10 quite easy, but also allows that magnetic marker to be readily secured on an article 30.

### Embodiment 2

Next, a second alternative embodiment of the present invention will be described, with reference to Fig. 2. As shown in the Fig. 2, a magnetic marker 100 is provided in accordance with the present embodiment, which is basically identical in structure to the above-described first embodiment, except that it includes: an additional casing 200 fixedly attached to a reverse side of casing 14, wherein such casing reverse side is shown as facing downwardly of the magnetic marker; an IC tag 202 (or wireless tag); and an antenna 204 associated with the IC tag, wherein both of the IC tag and antenna are provided in a space defined between the two casings 200 and 14. In the present embodiment, it is to be noted that those upper and lower casings are welded by ultrasonic fusing to each other, instead of the above-described connection of the two casings by securely engaging the projected portions 12A in the respective recessed portions 14A in the previous embodiment, and that the additional casing is also welded to the lower casing by ultrasonic fusing. Accordingly, it is appreciated that the IC tag 200 is accommodated within the magnetic marker 100, hence permitting both of those IC tag and magnetic marker to be attached on the article 30.

IC tags currently available are classified into: a read-only type of IC tag; a record able type of IC tag; and a rewritable type of IC tag. Of those IC tags, the recordable-type IC tag and rewritable-type IC tag permit storage therein of a data concerning completion of payment at cash register, which may certainly achieve an anti-theft function similar to the above-described operations of the present invention. Such approach will however result in a considerably increased cost for forming a suited detection gate for detecting the data stored in those IC tags. By contrast, according to the present invention, it is possible not only to use a read-only-type IC tag therein, but also to reduce costs for forming the detection gate. Further, in the present invention, any conventional detection gate may be directly used in conjunction with the magnetic marker. Accordingly, the present invention makes it possible to monitor article(s) by means of the magnetic marker(s), while at the same time checking and controlling the article(s) by means of the IC tag(s).

### Embodiment 3

Next, the third embodiment of the present invention will be described, with reference to Fig. 3. Fig. 3(A) shows a process wherein an adhesive sheet is securely attached to the casing of the magnetic marker. In this respect, one may consider preforming adhesive sheets, all in a predetermined size (the adhesive sheet is composed of the adhesive tape and the release paper), and adhesively attaching those preformed adhesive sheets to the magnetic markers, respectively. But, such method does not provide efficient workability in assembly of the magnetic markers. Hence, in the present embodiment, as shown in the Fig. 3(A), perforations are preformed in one unitary adhesive sheet 300 so as to define therein a plurality of perforated regions 302 each substantially corresponding in size to the magnetic marker. In assembly, the magnetic markers 310 are located within and fixedly adhered to the respective perforated regions 302.

Subsequently, all the magnetic markers 310 are fixedly adhered to the respective perforated regions 302, and Fig. 3(B) shows a resultant state of the adhesive sheet 300 with the magnetic markers attached thereto. Upon removing one of the magnetic markers 310 from that adhesive sheet 300, a localized area of the adhesive tape 22, corresponding to that one of magnetic makers 310, is cut off along the perforations of the corresponding perforated region 302, while being removed from the release paper, whereupon there is produced one resultant magnetic marker 310 with so cut-off adhesive tape 22 attached fast thereto. Then, the thus-produced magnetic marker 310 is securely adhered on an article, as shown in Fig. 1. With this arrangement, as clearly indicated in Fig. 3(A), a distance between one perforated region 302 and the other adjacent perforated region 302 can be reduced to as short as approx. 1 mm, thereby decreasing unusable waste portions of the adhesive sheet 300.

In general, the magnetic marker per se, by the reason of its structural property, is required to have a dimensions enough to cause the above-discussed magnetostrictive vibration. But, if the magnetic marker is formed larger than in a required dimensions, there will be raised the problem that some unrequited portions of materials are used in vain for forming the magnetic marker, and further, the increased dimensions of magnetic marker impairs the outer aesthetic appearance of the magnetic marker itself. Therefore, preferably, the magnetic marker should be formed in a smallest possible dimensions, insofar as it insures to cause a desired degree of magnetorestrictive vibration. With such conditions in view, according to the present embodiment, the length, width and thickness of the magnetic marker 301 are set to be 42 mm, 11.5 mm and 1.4 mm, respectively. It is noted here that the thickness of the marker excludes a thickness of the adhesive sheet 300 attached thereto, because the latter is so extremely thin enough to be disregarded in relation to the thickness of magnetic marker. Hence, it is safe to mention that the value 1.4 mm is an effective thickness of the magnetic marker for actual use, irrespective of whether the adhesive sheet 300 may be attached thereon or not.

### Embodiment 4

Next, the fourth embodiment of the present invention will be described, with reference to Fig. 4. This embodiment is directed to a device for producing the magnetic marker 10 described in the Embodiment 1. Fig. 4 depicts a whole structure of the device. According to the present embodiment, the device for producing magnetic marker, designated by 400, is comprised of: a transfer unit 408 having a plurality of support jigs 410 provided therewith; a base-side-casing supply unit 420; an adhesive applying unit 422; a magnet supply unit 426; a pair of vibrating-plate supply units 428 and 430; an cover-side-casing supply unit 432; an ultrasonic fusing unit 434, a discharge unit 436; and an outlet-side transfer unit 438.

The transfer unit 408 includes a pair of rollers 402 and 404 and an endless belt 406 which is extended between the two rollers, while being partway engaged about those particular two rollers. A plurality of support jigs 410 are fixedly disposed on that belt 405 in such a manner as to be distant from one another a predetermined distance. Each support jig 410 has a plate 412 provided on the outer surface thereof, the plate 412 being formed with recessions 412A adapted for receiving and retaining a plurality of the magnetic markers 10 and/or a plurality of the upper and lower casings 12 and 14, respectively, in a sequentially arrayed fashion. The thus-constructed transfer unit 408 is operable to move and stop the support jigs 410 at the respective aforementioned units, so that the magnetic markers and/or the casings are transferred to the respective units in an intermittent manner.

Generically stated, the base-side-casing supply unit 420 is provided with regard to base-side casings (wherein such term, base-side casings, refers to the afore-said lower casings 14 shown in the illustrative embodiments and shall be referred to as lower casings 14 hereinafter). Namely, this unit is operable to supply the lower casings 14 to the afore-said plate 412 of the support jig 410 and place the lower casings on that plate in a sequentially arrayed manner. The adhesive applying unit 422 is operable to spray and apply an adhesive 424 to the inner wall of each of the lower casings 14 retained on the support jig 410. The magnet supply unit 426 is operable to supply the low-coercive-force magnet 20 to the plate 412, the low-coercive-force magnet 20 being coated with the vinyl or plastic coating 18 (although Fig. 4 does not show such plastic coating 18 for the sake of simplicity). The vibrating-plate supply unit 428 is operable to supply the flat vibrating plates 16 to the plate 412, whereas the vibrating-plate supply unit 430 is operable to supply the transversely curved vibration plates 15 to that particular plate 412.

On the other hand, generically stated, the cover-side-casing supply unit 432 is provided with regard to cover-side casings (wherein such term, cover-side casings, refers to a the afore-said upper casings 12 shown in the illustrative embodiments and shall be referred to as upper casings 12 hereinafter). Namely, this unit is operable to supply the upper casings 12 to the lower casings 14, so that the upper casings are placed upon the respective lower casings. The ultrasonic fusing unit 434 is operable to effect ultrasonic fusing to weld the upper casings 12 to the lower casings 14, respectively. After resultant magnetic markers 10 have been produced through the foregoing units, the discharge unit 436 is operable to discharge such resultant magnetic markers from each of the support jigs 410 and displace the magnetic markers to an outlet-side transfer unit 438. The outlet-side transfer unit 438 is operable to transfer the magnetic markers 10 outwardly to a tray 440 or other similar container.

Now, a description will be made of detailed operations of the foregoing device in the present embodiment, on the understanding that the transfer unit 408 is operated intermittently to move and stop the support jigs 410 according to preset conditions. At first, a plurality of lower casings 14 are supplied by the base-side-casing supply unit 420 to the support jig 410 and placed in the respective recessions 412A formed in the plate 412 of the support jig. Then, the support jig 410, on which the lower casings 14 are retained in that manner, is transferred to a point in front of the adhesive applying unit 422. At this stage, the adhesive 424 is sprayed and applied by that adhesive applying unit 422 to the inner wall of each of the lower casings 14. Thereafter, the support jig 410 is transferred to a point in front of the magnet supply unit 426, and then the low-coercive-force magnets 20 are supplied to and placed in the respective lower casings 14 by the magnet supply unit 426. Here, the low-coercive-force magnets 20 are adhered to the respective lower casings 14, but, strictly stated, the outer surfaces of each of the low-coercive-force magnets 20 is coated with the vinyl or plastic coating 18, though not shown for the sake of simplicity, and therefore such plastic coating 18 of the low-coercive-force magnet 20 is fixedly adhered by the adhesive 424 to the lower casing 14.

Subsequent to the foregoing operations, the support jig 410 carrying the lower casings is transferred to the vibrating-plate supply unit 428 which is designed for sequential supply of the flat and transversely curved vibrating plates 16 and 15. Namely, at this stage, upon operation of the supply unit 428, the flat vibrating plates 16 are first sequentially supplied to and placed in the respective lower casings 14, after which, the transversely curved vibrating plates 15 are sequentially supplied to those particular lower casings 14, respectively, so that the transversely curved vibrating plates 15 are stacked upon the respective flat vibrating plates 16 that have been placed in the respective lower casings. Now, when all the low-coercive-force magnets 20 as well as all those two vibrating plates 15 and 16 have been supplied to and placed in the respective lower casings 14 in the above-described manners, the support jig 410 is further transferred to the cover-side-casing supply unit 432. At this stage, upon that cover-side-casing supply unit 432 being operated, the cover-side casings or the upper casings 12 are supplied to and placed on the lower casings 14, respectively. Thereafter, the support jig is transferred to the next ultrasonic fusing unit 434, and upon operation of the ultrasonic fusing unit 434, the thus-juxtaposed upper and lower casings 12 and 14 are subjected to ultrasonic fusing so as to weld those particular two casings to each other, and in that way, resultant magnetic markers 10 are produced. The resultant magnetic markers 10 are discharged from the corresponding support jig by operation of the discharge unit 436 and placed onto the outlet-side transfer unit 438. Then, upon operation of the outlet transfer unit 438, the magnetic markers 10 are transferred outwardly to the tray 440. In the present illustrative embodiment, the tray 440 is of the type capable of accommodating and retaining one hundred magnetic markers 10 therein, and therefore, when the magnetic markers 10 are filled in the tray 440 up to the numbers of one hundred, the tray 440 is replaced by a new empty tray of the same type by means of unshown mechanical unit.

As required, after the completion of all the above-described operations for producing resultant magnetic markers 10, an additional mechanical arrangement may be provided to cause the adhesive tapes 22 to attach fast on the resultant magnetic markers 10, respectively, in the manners described in the foregoing Embodiment 3. Accordingly, in the present embodiment, the above-described arrangement of mechanical units effectively achieves automated mass-production of a large number of the magnetic markers 10.

It should be understood that the present invention is not limited to the embodiments described above, but various modifications and alterations may be applied thereto, without departing from the gist and scopes of the appended claims for the invention. For example, the under-mentioned modifications and alternations may be applied to the present invention.
(1) The shapes, dimensions and materials set forth in the embodiments above are merely shown by way of example and may be changed appropriately as required. For example, the illustrated curvature of the transversely curved vibrating plate 15 is given by way of one example and may be changed and adjusted appropriately according to any specified shape and dimensions of the magnetic marker 10.
(2) In the previously described embodiments, the low-coercive-force magnet is employed as a means for application of bias magnetic field. Such employment of low-coercive-force magnet is particularly intended to facilitate the ease of demagnetization and therefore it is possible to use other suitable magnet with normal coercive force.
(3) The mechanical units and arrangements shown in the foregoing Embodiment 4 are also provided by way of one example, and therefore may be altered appropriately, with some changes given in the designs thereof, insofar as those alteration and changes attain the same effects set forth in the Embodiment 4. For example, a mechanical unit for supplying the third casing 200 to the support jig may be provided at a position before the base-side-casing supply unit 420, thereby making it possible to add an IC tag in the casing 200 to produce the magnetic markers 100 each having the IC tag provided therein, as described in the Embodiment 2. The ultrasonic fusing unit 434 is also given by way of one example, and therefore, any other various known suitable means may be used, insofar as it can fixedly connect the upper casings 14 with the lower casings 12, respectively.
(4) The magnetic markers in accordance with the present invention are not limited for use with articles in shops or retailers, but may be used widely for any other purposes that requires monitoring any illegal act of taking out things and giving alarm in the case of such illegal act.

### Industrial Applicability of the Invention

In accordance with the present invention, a pair of vibrating plates are provided in a casing of hard property in such a manner as to allow both of the two vibrating plates to generate magnetostrictive vibration, and a magnet is provided for application of a bias magnetic field that works to cause generation of such mangetostrictive vibration. This arrangement insures to cause vibration unless demagnetization is effected, which is suited for use in a security magnetic marker workable for giving alarm against any illegal act of taking out things or articles. The present invention is particularly suited for use with a security system for monitoring illegal acts of taking out goods or articles from retail store or the like.

## Claims

1. A magnetic marker which is **characterized by** comprising:
a first casing and a second casing, each being of hard property;
a first vibrating plate and a second vibrating plate, each being capable of generating magnetostrictive vibration; and
a substantially flat magnet which is to be magnetized and demagnetized by external action applied thereto,
and also **characterized in that:**
said first vibrating plate, said second vibrating plates and said substantially flat magnet are stacked on one another inside of one casing of hard property formed by said first and second casings, and one of said first and second vibrating plates, which is juxtaposed upon said substantially flat magnet, is formed in a substantially flat fashion, whereas another of said first and second vibrating plates is formed in a curved fashion.

2. The magnetic marker as described in Claim 1, which is **characterized by** further comprising: a third casing connected with said second casing; and an IC tag provided in a space defined between said second and third casings.

3. The magnetic marker as described in Claim 1 or 2, which is **characterized in that** said substantially flat magnet is coated with a plastic coating and **in that** said plastic coating is adhesively bonded to a side of said one casing, so that said substantially flat magnet is fixed to said one casing.

4. The magnetic marker as described in Claim 1, which is **characterized in that** outside dimensions of said one casing is such that the length, width and thickness of said one casing are 42 mm, 11.5 mm and 1.4 mm, respectively.

5. A device for producing the magnetic marker described in any one of Claims 1 to 4, which is **characterized by** comprising:
jig (s) having a capacity enough to allow resultant magnetic markers to be arrayed sequentially and retained therein;
a transfer means for transferring said support jig(s) in an intermittent manner;
a base-side-casing supply means for supplying a base-side casing(s) of hard property to said support jig(s), wherein said base-side casing(s) of hard property is one of said first and second casings which is to be situated on a base side of said one casing;
an adhesive applying means for applying an adhesive to an inner side of said base-side casing retained by said support jig(s);
a magnet supply means by which said substantially flat magnet is supplied to and placed on the thus-adhesive-applied inner side of said hard base casing;
a first vibrating-plate supply means by which said one of said first and second vibrating plates is supplied to and placed on said substantially flat magnet supplied by said magnet supply means, wherein said one of said first and second vibrating plates is formed in said substantially flat fashion;
a second vibrating-plate supply means by which said another of said first and second vibrating plates is supplied to and placed on said one of said first and second vibrating plates, wherein said another of said first and second vibrating plates is formed in said curved fashion;
a cover-side casing supply means by which a cover-side casing(s) of hard property is supplied to and placed upon said base-side casing(s) of hard property in which said substantially flat magnet and said one of said first and second vibrating plates have been supplied and placed;
a connecting means for connecting said cover-side casing and said base-side casing; and
a discharge means by which resultant magnetic markers, produced subsequent to said cover-side and base-side casings being connected together, are discharged outwardly from said support jig(s).

6. The device for producing the magnetic marker as described in Claim 5, which is **characterized in that** said connecting means is operable to effect ultrasonic fusing so that said cover-side and base-side casings are welded to each other by said ultrasonic fusing.

7. The device for producing the magnetic marker as described in Claim 5 or 6, which is **characterized by** further comprising an outlet-side transfer means by which said resultant magnetic markers discharged by said discharge means are transferred to an outside of said device.
